(19) Europäisches Patentamt
European Patent Office
Office européen des brevets

(11) Veröffentlichungsnummer: **0 152 819**
**B1**

(12) **EUROPÄISCHE PATENTSCHRIFT**

(45) Veröffentlichungstag der Patentschrift: **14.03.90**

(51) Int. Cl.$^5$: **G 03 F 7/021**

(21) Anmeldenummer: **85100889.6**

(22) Anmeldetag: **29.01.85**

# (54) Lichtempfindliches Gemisch auf Basis eines Diazoniumsalz-Polykondensationprodukts und daraus hergestelltes lichtempfindliches Aufzeichnungsmaterial.

(30) Priorität: **08.02.84 DE 3404366**

(43) Veröffentlichungstag der Anmeldung:
**28.08.85 Patentblatt 85/35**

(45) Bekanntmachung des Hinweises auf die Patenterteilung:
**14.03.90 Patentblatt 90/11**

(84) Benannte Vertragsstaaten:
**AT BE CH DE FR GB IT LI NL SE**

(56) Entgegenhaltungen:
**FR-A-2 234 583**
**US-A-4 123 276**

(73) Patentinhaber: **HOECHST AKTIENGESELLSCHAFT**
**Postfach 80 03 20**
**D-6230 Frankfurt am Main 80 (DE)**

(72) Erfinder: **Pawlowski, Georg, Dr. Dipl.-Chem.**
**Blücherstrasse 48**
**D-6200 Wiesbaden (DE)**

**EP 0 152 819 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

**Beschreibung**

Die Erfindung betrifft ein lichtempfindliches Gemisch, das ein Diazoniumsalz-Polykondensationsprodukt und ein polymeres Bindemittel enthält und das insbesondere zur Herstellung von Druckplatten geeignet ist.

Aus der DE—A—20 24 244 (=US—A—3 867 147) ist es bekannt, lichtempfindliche Aufzeichnungsmaterialien aus Mischkondensationsprodukten von kondensationsfähigen Diazoniumsalzen und anderen nicht lichtempfindlichen kondensationsfähigen Verbindungen, gegebenenfalls in Kombination mit polymeren Bindemitteln, zur Herstellung von Druckplatten zu verwenden. Diese lichtempfindlichen Materialien zeichnen sich durch hohe Lichtempfindlichkeit und gute Druckauflagen aus. Die Auflage ist besonders hoch bei Verwendung von wasserunlöslichen Bindemitteln, z.B. Polyvinylformal, doch lassen sich solche Schichten nur mit solchen Entwicklern sauber verarbeiten, die einen erheblichen Anteil an flüchtigen organischen Lösungsmitteln enthalten.

Aus der DE—A—31 30 987 sind ähnliche Gemische bekannt, die als Bindemittel Styrol-Maleinsäureanhydrid-Mischpolymerisate enthalten und die sich mit rein wäßrigen alkalischen Lösungen entwickeln lassen. Diese Bindemittel haben in der Regel Säurezahlen weit über 100.

Die mit diesen Gemischen erhaltenen Druckplatten liefern jedoch geringere Druckauflagen als solche, die in wäßrigem Alkali unlösliche Bindemittel enthalten.

Aus der DE—A—30 36 077 sind ferner entsprechende Gemische bekannt, die als Bindemittel Polymere mit seitenständigen Alkenylsulfonylurethangruppen enthalten. Auch diese Gemische lassen sich mit rein wäßrigen Lösungen entwickeln. Bei der Verarbeitung zu Flachdruckplatten ergeben sie jedoch lichtgehärtete Schichten, deren Farbannahme nicht zufriedenstellend ist.

Aus der US—A—2 861 058 sind lichtempfindliche Polymere bekannt, die seitenständige Zimtsäuregruppen und Dicarbonsäuremonoestergruppen enthalten. Diese Polymeren enthalten einen relativ hohen Anteil an Säuregruppen, dem Säurezahlen von mindestens 100 bis etwa 300 entsprechen, um die Schichten in wäßrigem Alkali löslich zu machen.

In der DE—A—27 51 060 sind lichtempfindliche Gemische aus einem lichtempfindlichen Harz und einem Celluloseetherdicarbonsäurehalbester beschrieben. Die Gemische werden zur Herstellung von Photoresistschichten verwendet und zeichnen sich durch gute Ätzfestigkeit aus. Wegen der stark hydrophilen Natur der als Grundkörper dienenden Cellulose haben diese Polymeren meist keine ausreichende Oleophilie, um in druckenden Bildstellen von Druckplatten verwendet zu werden. Auch ist es schwierig, das in Molekülgröße und Struktur vorgegebene Cellulosemolekül durch Substitution in seinen Eigenschaften weit genug zu variieren.

In der FR—A—2 234 583 wird ein Gemisch beschrieben, das eine lichtempfindliche Diazoverbindung und ein Bindemittel enthält, das durch Umsetzen eines Hydroxyl- oder Carboxylgruppen enthaltenden Polymeren mit einem Vernetzungsmittel erhalten wird, das Isocyanat-, Epoxid- oder Säureanhydridgruppen enthält. Durch die Vernetzung wird die Löslichkeit des Polymeren herabgesetzt. Soweit dadurch Produkte mit hoher Druckauflage erreicht werden, ist zur Entwicklung der Zusatz organischer Lösemittel erforderlich.

In der US—A—4 123 276 wird ein entsprechendes Gemisch beschrieben, das Halbestereinheiten aus einem cyclischen Säureanhydrid und einer Hydroxyalkyl(meth)acrylateinheit enthalten. Die aus diesen Gemischen erhaltenen Druckplatten haben nur eine begrenzte Lagerfähigkeit.

Aufgabe der Erfindung war es, ein negativ arbeitendes lichtempfindliches Gemisch vorzuschlagen, das für die Herstellung von Druckplatten, insbesondere Flachdruckplatten, geeignet ist, das alle Vorzüge der bekannten Gemische auf Basis von Diazoniumsalz-Polykondensationsprodukten aufweist, das sich mit praktisch lösungsmittelfreien neutralen oder alkalischen wäßrigen Lösungen entwickeln läßt und das zugleich Druckplatten mit hoher Auflage und guter Farbannahme sowie mit hoher Lagerfähigkeit ergibt, wie sie bisher nur mit solchen Druckplatten erreichbar waren, die zur Entwicklung den Zusatz von größeren Mengen organischer Lösungsmittel erforderten.

Erfindungsgemäß wird ein lichtempfindliches Gemisch vorgeschlagen, das ein Diazoniumsalz-Polykondensationsprodukt und ein nicht lichtempfindliches polymeres Bindemittel mit seitenständigen Carboxylgruppen enthält, das in wäßrig-alkalischen Lösungen löslich oder mindestens quellbar ist.

Das erfindungsgemäße Gemisch ist dadurch gekennzeichnet, daß das Bindemittel ein Umsetzungsprodukt eines intramolekularen Anhydrids einer organischen Di- oder Tricarbonsäure mit einem Vinylalkoholeinheiten enthaltenden synthetischen Polymeren ist, das keine weiteren zur Umsetzung mit Säureanhydriden befähigten funktionellen Gruppen enthält.

Das Säureanhydrid leitet sich bevorzugt von einer Dicarbonsäure ab und kann einen, zwei oder mehrere Ring enthalten.

Besonders bevorzugte Bindemittel werden durch Umsetzen mit Säureanhydriden einer der Formeln I, II oder III

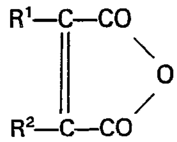 (I)

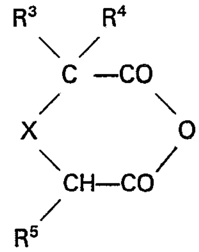 (II)

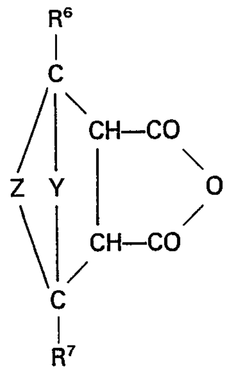 (III)

erhalten worin

$R^1$ und $R^2$ einzeln Wasserstoffatome oder Alkylgruppen bedeuten oder miteinander zu einem aromatischen oder heteroaromatischen, gegebenenfalls substituierten und ggf. teilweise hydrierten 5- oder 6-gliedrigen Ring verbunden sind, an den bis zu zwei aromatische oder cycloaliphatische Ring ankondensiert sein können,

$R^3$, $R^4$ und $R^5$ einzeln Wasserstoffatome der Alkylgruppen bedeuten oder

$R^3$ und $R^5$ miteinander zu einem ggf. substituierten gesättigten oder ungesättigten aliphatischen Ring verbunden sind, der einschließlich X fünf oder sechs Ringglieder haben kann,

$R^6$ und $R^7$ Wasserstoffatome oder Alkylgruppen,

X eine Einfachbindung, eine 1,1-Alkylengruppe, eine 1,1-Cycloalkylengruppe, die ggf. substituiert sind, ein Sauerstoff- oder Schwefelatom,

Y ein Sauerstoff- oder Schwefelatom, eine 1,1- oder 1,2-Alkylengruppe oder eine 1,2-Alkenylengruppe, an die ggf. ein aromatischer oder cycloaliphatischer Ring ankondensiert ist, und

Z die zur Vervollständigung eines gesättigten oder ungesättigten ggf. substituierten Rings erforderlichen Ringglieder bedeuten, wobei an diesen Ring bis zu zwei aromatische oder cycloaliphatische Ringe ankondensiert sein können.

Wenn $R^1$, $R^2$, $R^3$, $R^4$, $R^5$, $R^6$ oder $R^7$ Alkylgruppen bedeuten, haben diese im allgemeinen 1 bis 4, bevorzugt 1 bis 2 Kohlenstoffatome. Substituenten, die an die aromatischen oder cycloaliphatischen Ringe gebunden sein können, sind z.B. Alkylgruppen, Alkoxygruppen, Halogenatome, Nitrogruppen oder Carboxylgruppen.

Beispiele für geeignete Säureanhydride sind:

Maleinsäureanhydrid und Derivate,

z.B. Dimethylmaleinsäureanhydrid oder Citraconsäureanhydrid,

Bernsteinsäureanhydrid und Derivate, z.B. Methylbernsteinsäureanhydrid,

Glutarsäureanhydrid und Derivate, z.B. 3 - Methylglutarsäureanhydrid, 3,3 - Tetramethylen - glutarsäureanhydrid oder Camphersäureanhydrid,

3 - Oxa - glutarsäureanhydrid und Derivate,

Phthalsäureanhydrid und Substitutionsprodukte, z.B. Chlor-, Nitro- oder Carboxyphthalsäureanhydrid,

teilweise oder vollständig hydrierte Phthalsäureanhydride, z.B. Hexahydrophthalsäureanhydrid oder Cyclohexen - 1,2 - dicarbonsäureanhydrid,

Naphthalin - 2,3 - dicarbonsäureanhydrid oder Naphthalin - 1,8 - dicarbonsäureanhydrid und deren Substitutionsprodukte,

Pyridin - o - dicarbonsäureanhydrid und dessen Substitutionsprodukte,

Pyrazin - o - dicarbonsäureanhydrid und dessen Substitutionsprodukte,

Furan - o - dicarbonsäureanhydrid oder Furan - 2,5 - dicarbonsäureanhydrid, deren Substitutionsprodukte sowie deren teilweise oder vollständig hydrierte Derivate,

Thiophen - o - dicarbonsäureanhydrid oder Thiophen - 2,5 - dicarbonsäureanhydrid, deren Substitutionsprodukte sowie deren ganz oder teilweise hydrierte Derivate,

di- oder polycyclische Anhydride, die durch Diels-Alder-Reaktion eines Diens mit Maleinsäureanhydrid entstehen, z.B. die Additionsprodukte aus Furan, Anthracen, Cyclohexadien - 1,3 oder Cyclopentadien und Maleinsäureanhydrid.

Bevorzugt werden die Reaktionsprodukte mit Malein-, Phthal-, Bernstein- und 3 - Oxa - glutarsäureanhydrid.

Als Polymere mit Vinylalkoholeinheiten sind teilverseifte Polyvinylester, Polyvinylacetale mit freien Hydroxygruppen sowie entsprechende Umsetzungsprodukte von Copolymeren bzw. Copolymerisaten mit Vinylester- oder Vinylacetal- oder Vinylalkoholeinheiten geeignet.

Das Molekulargewicht der Carboxylgruppen enthaltenden Bindemittel kann innerhalb weiter Bereiche variieren. Im allgemeinen werden Bindemittel mit mittleren Molekulargewichten zwischen 5.000 und etwa 200.000 und darüber, verzugsweise zwischen 10.000 und 100.000 eingesetzt. Die Säurezahl der Bindemittel kann im allgemeinen zwischen 5 und 80, bevorzugt zwischen 10 und 70 liegen. Die Säurezahlen der Polymeren sind damit deutlich niedriger als die der bischer in lichtempfindlichen Gemischen gleicher Gattung verwendeten Bindemittel, soweit diese Gemische für eine wäßrige Entwicklung geeignet und bestimmt waren.

Die Umsetzung zwischen Säureanhydrid und Vinylalkoholeinheiten enthaltendem Polymeren verläuft sehr übersichtlich und in vielen Fällen quantitativ; sie läßt sich daher sehr gut reproduzieren. Es ist deshalb möglich, die gewünschte Säurezahl des Bindemittels genau und reproduzierbar, z.B. für die Verwendung eines bestimmten Entwicklers, einzustellen.

Die Reaktion kann in Ketonen, z.B. Butanon, oder Tetrahydrofuran, Dioxan oder anderen Ethern durchgeführt werden. Als Katalysatoren werden zweckmäßig tertiäre Amine eingesetzt. Im allgemeinen werden auf 100 Gewichtsteile Vinylalkoholeinheiten enthaltendes Polymeres 0,5 bis 20 Gewichtsteile Anhydrid, 1000 bis 3000 Gewichtsteile Lösungsmittel und 0,5 bis 5 Gewichtsteile tertiäres Amin verwendet.

Als Diazoniumsalz-Polykondensationsprodukte sind Kondensationsprodukte kondensationsfähiger aromatischer Diazoniumsalze, z.B. von Diphenylamin - 4 - diazoniumsalzen, mit Aldehyden, bevorzugt Formaldehyd, geeignet. Mit besonderem Vorteil werden Mischkondensationsprodukte verwendet, die außer den Diazoniumsalzeinheiten noch andere, nicht lichtempfindliche Einheiten enthalten, die von kondensationsfähigen Verbindungen, insbesondere aromatischen Aminen, Phenolen, Phenolethern, aromatischen Thioethern, aromatischen Kohlenwasserstoffen, aromatischen Heterocyclen und organischen Säureamiden, abgeleitet sind. Diese Kondensationsprodukte sind in der DE—A—20 24 244 beschrieben. Allgemein sind alle Diazoniumsalz-Polykondensationsprodukte geeignet, die in der DE—A—27 39 774 beschrieben sind.

Die Diazoniumsalzeinheiten $A—N_2X$ leiten sich bevorzugt von Verbindungen der Formel $(R^8—R^9—)_pR^{10}—N_2X$ ab, wobei

X das Anion der Diazoniumverbindung,

p eine ganze Zahl von 1 bis 3,

$R^8$ einen aromatischen Rest mit mindestens einer zur Kondensation mit aktiver Carbonylverbindung befähigten Position,

$R^{10}$ eine Phenylengruppe,

$R^9$ eine Einfachbindung oder eine der Gruppen:

$—(CH_2)_q—NR^{11}—$,
$—O—(CH_2)_r—NR^{11}—$,
$—S—(CH_2)_r—NR^{11}—$,
$—S—CH_2CO—NR^{11}—$,
$—O—R^{12}—O—$,
$—O—$
$—S—$ oder
$—CO—NR^{11}—$

bedeuten, worin

q eine Zahl von 0 bis 5,

r eine Zahl von 2 bis 5,

$R^{11}$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und

$R^{12}$ eine Arylengruppe mit 6 bis 12 C-Atomen ist.

Die erfindungsgemäßen Gemische enthalten im allgemeinen 5 bis 90, bevorzugt 10 bis 70 Gew.-% Diazoniumverbindung und 95 bis 10, bevorzugt 90 bis 30 Gew.-% polymeres Bindemittel.

Zur Stabilisierung des lichtempfindlichen Gemisches ist es vorteilhaft, diesem eine Verbindung mit Säurecharakter zuzusetzen. In Betracht kommen Mineralsäuren und starke organische Säuren, von denen Phosphorsäure, Schwefelsäure, Perchlorsäure, Borsäure oder p-Toluolsulfonsäure bevorzugt werden. Eine besonders gut geeignete Säure ist die Phosphorsäure.

Den Gemischen können ferner Weichmacher, Haftvermittler, Farbstoffe, Pigmente und Farbbildner zugesetzt werden.

Art und Menge dieser Zusätze richten sich nach dem für das lichtempfindliche Gemisch vorgesehenen Anwendungsgebiet. Dabei ist grundsätzlich zu beachten, daß die beigefügten Stoffe keinen übergroßen Anteil des für die Vernetzung notwendigen aktinischen Lichts absorbieren und dadurch die praktische Lichtempfindlichkeit herabsetzen.

Die lichtempfindlichen Gemische können ferner Farbstoffe und/oder Pigmente enthalten, die sowohl als Kontrastmittel als auch schichtverfestigend wirken können. In Frage kommende Farbstoffe sind

beispielsweise in den US—A—3 218 167 und 3 884 693 angegeben. Besonders geeignet sind z.B. Viktoriareinblau FGA, Renolblau B2G-H (C.I. 74160), Kristallviolett oder Rhodamin 6 GDN (C.I. 45160). Zur Erhöhung des Bildkontrastes nach dem Belichten können Metanilgelb (C.I. 13065), Methylorange (C.I. 13025) oder Phenylazodiphenylamin verwendet werden.

Für gewisse Zwecke kann es vorteilhaft sein, den erfindungsgemäßen lichtempfindlichen Gemischen weitere Polymere in Mengen bis zu 40 Gew.-% der oben beschriebenen polymeren Bindemittel zuzusetzen. Für diesen Zweck gut geeignete Harz sind solche, welche Hydroxyl- oder Carboxylgruppen oder Amid- bzw. Urethangruppierungen aufweisen.

In vielen Fällen führt der Zusatz anderer als der beschriebenen Carboxylgruppen enthaltenden Bindemittel zu einer unerwünschten Verschlechterung zahlreicher Eigenschaften des lichtempfindlichen Gemisches, die zumeist auf eine Unverträglichkeit mit den einzelnen Schichtbestandteilen zurückzuführen ist. Die oben genannten gut geeigneten Zusatzharze können aber beispielsweise zu einer Verbesserung der Abriebbeständigkeit und damit zu einer Erhöhung der Druckauflage führen, wenn das Gemisch Verwendung in einer Flachdruckform findet.

Als bevorzugte Zusatzpolymere sind amid- und urethangruppenhaltige Polymere zu nennen. So lassen sich beispielsweise die in der DE—A—22 18 821 verwendeten Polyamide oder die aus der DE—A—29 48 554 bekannten Polyurethane bzw. die aus den DE—A—20 53 363 und 20 53 364 bekannten Sulfonylurethane für den oben genannten Zweck vorteilhaft einsetzen.

Als besonders geeignet haben sich Zusätze von Polyamiden und Polyurethanen erwiesen, welche etwa das gleiche Molekulargewicht aufweisen wie die in der lichtempfindlichen Mischung eingesetzten Carboxylgruppen enthaltenden Polymeren.

Im Rahmen der Erfindung wird folgende gewichtsmäßige Verteilung der wichtigsten Zusätze in dem lichtempfindlichen Gemisch bevorzugt, bezogen auf den Gehalt an nichtflüchtigen Bestandteilen, d.h. die Bestandteile der nach dem Verdampfen des Lösemittels erhaltenen festen lichtempfindlichen Schicht.

| | |
|---|---|
| Bindemittel | 30 bis 90% |
| Diazoniumsalz-Polykondensationsprodukt: | 10 bis 70% |
| Säure: | 0 bis 10% |
| Farbstoff oder Pigment: | 0 bis 12% |
| Belichtungskontrastgeber (Farbstoff): | 0 bis 5% |

Die Beschichtung des Trägermaterials erfolgt aus entsprechenden organischen Lösemitteln oder Lösemittelgemischen, und zwar im allgemeinen durch Gießen, Sprühen oder Eintauchen.

Als Lösemittel sind Alkohole, Ketone, Ester, Ether und dergleichen geeignet. Als günstige Lösemittel haben sich dabei die Partialether der Glykole oder der Ketoalkohole erwiesen, z.B. Ethylenglykolmonomethylether.

Als Schichtträger eignen sich z.B. Magnesium, Zink, Kupfer, mechanisch, chemisch und elektrochemisch aufgerauhtes Aluminium, anodisiertes Aluminium, Stahl, aber auch Polyester- oder Celluloseacetatfolie, Perlongaze etc., deren Oberfläche bei Bedarf einer Vorbehandlung unterworfen sein kann. Das Trägermaterial kann dabei als endgültiger Schichtträger fungieren oder als temporäres Trägermaterial, von dem die lichtempfindliche Schicht auf das zu bearbeitende Werkstück mittels Laminieren übertragen wird.

Das mit den lichtempfindlichen Gemischen hergestellte Aufzeichnungsmaterial dient einerseits zur Herstellung von Bildern auf geeigneten Trägern bzw. Empfangsblättern, andererseits zur Herstellung von Reliefs, die als Druckformen, Siebe, Reservagen und dgl. Anwendung finden.

Darüber hinaus ist es aber auch möglich, die lichtempfindlichen Gemische zur Herstellung von durch UV-Strahlung härtbaren Lacken zu verwenden, die als Oberflächenschutz eingesetzt werden können, oder zur Formulierung von UV-härtbaren Druckfarben.

Besonders bevorzugt wird das Gemisch zur Herstellung von Flachdruckformen verwendet, wobei als Trägermaterial Aluminium bevorzugt wird.

Besonders bevorzugt wird Aluminium, das für diesen Zweck in üblicher Weise vorbehandelt wird, z.B. durch mechanisches, chemisches oder elektrochemisches Aufrauhen und ggf. anschließende anodische Oxidation. Eine weitere Behandlung dieses Trägermaterials, z.B. mit Polyvinylphosphonsäure, Alkalisilikat, Phosphat, Hexafluorozirkonat, Chromat, Borat, Polyacrylamid und Cellulosederivaten, ist vorteilhaft.

Die Verarbeitung der aus den Gemischen erhaltenen Aufzeichnungsmaterialien erfolgt in bekannter Weise durch bildmäßiges Belichten und Auswaschen der unbelichteten Schichtbereiche mit einem geeigneten Entwickler.

Die Belichtung des Aufzeichnungsmaterials erfolgt in bekannter Weise unter einer Vorlage mit Kopierlichtquellen, die einen möglichst hohen Spektralanteil im nahen Ultraviolettbereich emittieren. Sie kann auch durch Laserbestrahlung erfolgen. Geeignet für die Bestrahlung sind leistungsgerechte kürzerwellige Laser, beispielsweise Ar-Laser, Krypton-Ionen-Laser, Helium/Cadmium-Laser, die etwa zwischen 300 und 600 nm emittieren, aber für einige Schichten auch $CO_2$-Laser, welche bei 10,6 µm emittieren, oder YAG-Laser, die bei 1,06 µm emittieren.

Als Entwicklerlösungen werden neutrale oder alkalische wäßrige Lösungen mit einem pH-Wert im Bereich von 6 bis 14, vorzugsweise 7,5 bis 12, verwendet, die Puffersalze, z.B. wasserlösliche

Alkaliphosphate, -silikate, -borate, -carbonate, -acetate oder -benzoate, enthalten. Als weitere Bestandteile werden Netzmittel, vorzugsweise anionische Netzmittel, und ggf. wasserlösliche Polymere verwendet. Die Lösung kann auch geringe Mengen, z.B. bis zu 5, bevorzugt nicht mehr als 2 Gew.-% an mit Wasser mischbaren organischen Lösungsmitteln enthalten. Bevorzugt werden schwerflüchtige Lösungsmittel, z.B. araliphatische Alkohole, deren Dampfdruck bei der Handhabung des Entwicklers nicht ins Gewicht fällt.

Die Entwicklung kann in bekannter Weise durch Tauchen, Besprühen, Bürsten oder Tamponieren erfolgen.

Die erfindungsgemäß eingesetzten Carboxylgruppen enthaltenden Bindemittel lassen sich leicht und reproduzierbar aus billigen Ausgangsstoffen herstellen. Sie weisen eine gute Verträglichkeit mit anderen Schichtbestandteilen auf und lassen sich gut miteinander und mit anderen Polymeren zu homogenen Schichten kombinieren.

Die Schichten sind wenig kratzempfindlich, lassen sich leicht entwickeln und ergeben eine sehr gute Differenzierung zwischen Bild- und Nichtbildstellen und eine steile Gradation.

Von besonderem Vorteil ist die hohe Druckauflage, die mit den aus dem erfindungsgemäßen Material hergestellten Druckformen erreicht wird sowie die gute Farbannahme. Die Druckschablonen weisen ebenfalls eine hohe Resistenz gegenüber alkalischen Entwicklern auf.

Es ist in hohem Maße überraschend, daß sich die erfindungsgemäßen Materialien trotz der ungewöhnlich niedrigen Säurezahlen der Bindemittel leicht mit umweltfreundlichen neutralen oder alkalischen wäßrigen Lösungen entwickeln lassen.

Die folgenden Beispiele sollen die Erfindung erläutern. Gewichtsteile und Volumteile stehen im Verhältnis von g/ccm, Prozentangaben und Mengenverhältnisse sind in Gewichtseinheiten zu verstehen, wenn nichts anderes angegeben ist.

Beispiel 1

50 Gt eines Polyvinylbutyrals mit einem Molekulargewicht von etwa 70.000 bis 80.000, das 71% Vinylbutyral-, 2% Vinylacetat- und 27% Vinylalkoholeinheiten enthält, und 4 Gt Maleinsäureanhydrid werden unter Erwärmen in 725 Gt Methylethylketon gelöst. Zur klaren Lösung wird 1 Gt Triethylamin hinzugefügt und die Lösung fünf Stunden zum Rückfluß erhitzt. Nach Abkühlen wird die Lösung filtriert und in 10.000 Gt destilliertes Wasser eingetropft, wobei man ein weißes, faseriges Produkt erhält, welches abgesaugt und bis zur Gewichtskonstanz im Vakuum bei 40°C getrocknet wird.

Ausbeute: 52 Gt
Analyse: C 61,9%; H 9,3%
Säurezahl: 30.

Ein Beschichtungslösung aus

62 Gt des oben beschriebenen Polymeren,
21 Gt eines Diazoniumsalz-Polykondensationsprodukts, hergestellt aus 1 mol 3 - Methoxy - diphenylamin - 4 - diazoniumsulfat und 1 mol 4,4' - Bis - methoxymethyl - diphenylether in 85%iger Phosphorsäure und isoliert als Mesitylensulfonat,
2,5 Gt Phosphorsäure (85%),
3 Gt Viktoriareinblau FGA (C.I. Basic Blue 81) und
0,7 Gt Phenylazodiphenylamin in
2570 Gt Ethylenglykolmonomethylether und
780 Gt Tetrahydrofuran

wird auf eine Aluminiumfolie, welche durch Bürsten mit einer wässrigen Schleifmittelsuspension aufgerauht und danach mit einer 0,1 %igen wässrigen Lösung von Polyvinylphosphonsäure vorbehandelt worden ist, aufgebracht und anschließend getrocknet.

Die so erhaltene Kopierschicht, die ein Schichtgewicht von 0,95 g/m$^2$ aufweist, wird unter einer Negativvorlage 30 Sekunden mit einer Metallhalogenid-Lampe von 5 kW Leistung belichtet.

Die belichtete Schicht wird mit einer Entwickler-Lösung folgender Zusammensetzung

5,0 Gt Natriumoctylsulfat,
1,5 Gt Natriummetasilikat ×5 Wasser,
1 Gt Trinatriumphosphat ×12 Wasser,
0,5 Gt Dinatriumhydrogenphosphat ×12 Wasser,
92,0 Gt Wasser

mittels eines Plüschtampons behandelt, wobei die nichtbelichteten Schichtbereiche sauber entfernt werden, und anschließend mit Wasser abgespült und getrocknet.

In der Kopie ist die Stufe 4 eines Silberfilm-Halbtonstufenkeils mit einem Dichteumfang von 0,15 bis 1,50, wobei die Dichteinkremente 0,15 betragen, noch voll gedeckt.

Die derart erhaltene Druckplatte liefert an einer Bogenoffsetmaschine eine Auflage von 40.000 Bögen.

Beispiel 2

Ein Polymeres mit einem Gehalt von 61,3% C und 9,3% H und mit der Säurezahl 8 wird ähnlich wie in

Beispiel 1 beschrieben durch Umsetzung von 100 Gt des dort angegebenen Polyvinylbutyrals mit 1 Gt Maleinsäureanhydrid in 1300 Gt Methylethylketon hergestellt, in Wasser ausgefällt und getrocknet.

Mit diesem Bindemittel wird eine Beschichtungslösung der in Beispiel 1 beschriebenen Zusammensetzung hergestellt.

Diese Beschichtungslösung wird auf eine in Salpetersäure elektrochemisch aufgerauhle und anschließend anodisierte Aluminiumfolie, die mit Polyvinylphosphonsäure nach behandelt worden ist, aufgebracht und getrocknet. Das Schichtgewicht beträgt etwa 1 g/m$^2$.

Die Kopierschicht wird unter einer Negativvorlage 30 Sekunden mit einer Metallhalogenidlampe von 5 kW Leistung belichtet und dann mit einem Entwickler folgender Zusammensetzung entwickelt:

5,0 Gt Natriumoctylsulfat,
1,5 Gt Natriummetasilikat ×5 Wasser,
1 Gt Trinatriumphosphat ×12 Wasser,
1 Gt Phenoxyethanol,
91,5 Gt Wasser.

Bereits nach wenigen Sekunden lösen sich die Nichtbildstellen der Kopierschicht ab, und nach Überwischen mitels eines Plüschtampons wird mit Wasser abgespült und getrocknet.

Die Kopie zeigt gleiche Eigenschaften wie die in Beispiel 1 beschriebene. Nach der Konservierung wird die Platte in eine Bogenoffsetmaschine eingespannt und liefert 220.000 gute Drucke.

Beispiel 3

25 Gt des in Beispiel 1 angegebenen Polyvinylbutyrals und 10 Gt Maleinsäureanhydrid werden in 400 Gt Methylethylketon gelöst, mit 1 Gt Triethylamin versetzt und 5 Stunden zum Rückfluß erhitzt.

Nach Ausfällen in Wasser erhält man ein Polymeres mit 59,9% C, 8,5% H und der Säurezahl 70.

Eine Beschichtungslösung aus

34,1 Gt des oben beschriebenen Polymeren,
11,4 Gt des in Beispiel 1 beschriebenen Diazoniumsalz-Polykondensationsproduktes,
1,5 Gt Phosphorsäure (85%),
1,1 Gt Kristallviolett (C.I. 42555) und
1,1 Gt Phenylazodiphenylamin in
1600 Gt Ethylenglykolmonomethylether

wird auf den in Beispiel 2 angegebenen Schichtträger aufgebracht. Das Schichtgewicht beträgt nach dem Trocknen 0,98 g/m$^2$.

Die Verarbeitung wird ähnlich wie in Beispiel 1 durchgeführt. Dabei wird die Druckform nach bildmäßiger Belichtung eine Minute in den Entwickler getaucht und anschließend mit Wasser abgebraust. Die so erhaltene Kopierschicht ist ausgezeichnet entwickelt, d.h. daß auch sehr feine Raster- und Strichelemente differenziert wiedergegeben sind, keine Farbschleier oder Schichtreste auf Nichtbildstellen vorhanden sind und eine hohe Auflösung erreicht wird.

Auf einer Bogenoffsetmaschine erhält man viele Drucke sehr guter Qualität.

Beispiel 4

46 Gt des in Beispeil 1 beschriebenen Polyvinylbutyrals und 3,6 Gt Phthalsäureanhydrid werden in 690 Gt Methylethylketon klar gelöst und nach Zugabe von 1,1 Gt Triethylamin 5 Stunden zum Rückfluß erhitzt. Die erkaltete Lösung wird in 10.000 Gt Wasser eingetropft, das ausgefallene faserige, weiße Polymere abgesaugt und getrocknet.

Ausbeute: 49 Gt
Analyse: 61,9% C; 9,2% H;
Säurezahl: 16
Eine Beschichtungslösung aus

35,1 Gt des oben beschriebenen Polymeren,
23,4 Gt eines Diazoniumsalz-Kondensationsproduktes, hergestellt durch Kondensieren von 1 mol 3 - Methoxy - diphenylamin - 4 - diazoniumsulfat mit 1 mol 4 - Methyl - 4' - methoxymethyl - diphenylether und anschließend mit 1 mol 4,4' - Bis - methoxymethyl - diphenylether in 85 %iger Phosphorsäure und isoliert als Mesitylensulfonat,
2,1 Gt Phosphorsäure (85%),
1,5 Gt Viktoriareinblau FGA und
1,1 Gt Phenylazodiphenylamin in
1900 Gt Ethylenglykolmonomethylether

wird auf den in Beispiel 2 angegebenen Schichtträger zu einem Trockenschichtgewicht von 0,95 g/m$^2$ aufgebracht.

Nach bildmäßiger Belichtung und Entwicklung mit der in Beispiel 1 beschriebenen Entwicklerlösung erhält man eine Kopie mit sehr hoher Auflösung und steiler Gradation.

Beim Andruck nehmen die Bildstellen die Druckfarbe sehr rasch an. Das Andruckverhalten der gesäuberten Druckplatte wird durch die Einwirkung verschiedener Verarbeitungschemikalien nicht negativ beeinflußt.

Beispiele 5 bis 8

Entsprechend Beispiel 4 werden folgende Säureanhydride umgesetzt:

Beispeil 5: cis-Hexahydrophthalsäureanhydrid
Beispiel 6: 4,5-Dichlor-phthalsäureanhydrid
Beispiel 7: 3-Nitro-phthalsäureanhydrid
Beispiel 8: Trimellithsäureanhydrid

Es werden in allen Fällen praktisch quantitative Ausbeuten der entsprechenden Polymeren erhalten.

Die mit diesen Polymeren analog Beispiel 4 durch Auftragen auf einen Schichtträger wie in Beispiel 2 hergestellten Beschichtungen lassen sich mit zunehmender Leichtigkeit mit den in Beispiel 1 oder 2 beschriebenen Entwicklerlösungen entwickeln.

Die in allen Fällen gut differenzierten Kopien ergeben nach dem Einspannen in eine Bogenoffsetmaschine Drucke hoher Auflösung und guter Qualität.

Beispiel 9

20 Gt des in Beispiel 1 beschriebenen Polyvinylbutyrals und 1,6 Gt Pyridin-2,3-dicarbonsäureanhydrid werden in 280 Gt Methylethylketon gelöst. Nach Zugabe von 0,5 Gt Triethylamin wird die klare Lösung 5 Stunden zum Rückfluß erhitzt. Dicke erkaltete Lösung wird in 5000 Gt Wasser eingetropft und das ausgefällte Polymere abgesaugt und getrocknet.

Man erhält 20,5 Gt eines weißen, spröden Polymeren.
Analyse: C 62,2%, H 9,4%, N 0,6%
Säurezahl: 17
Eine Beschichtungslösung aus

88,7 Gt des oben beschriebenen Polymeren,
30 Gt des in Beispiel 1 beschriebenen Diazoniumsalz-Kondensats,
4,6 Gt Phosphorsäure (85%),
4,3 Gt Viktoriareinblau FGA und
1,1 Gt Phenylazodiphenylamin in
3675 Gt Ethylenglykolmonomethylether und
1115 Gt Tetrahydrofuran

wird auf den Beispiel 2 angegebenen Schichtträger aufgetragen und getrocknet. Das Schichtgewicht beträgt 1,03 $g/m^2$.

Die so erhaltene Kopierschicht wird unter einer Negativvorlage 25 Sekunden lang mit einer Metallhalogenidlampe von 5 kW Leistung belichtet.

Die belichtete Schicht läßt sich innerhalb weniger Sekunden mit einer Entwickler-Lösung folgender Zusammensetzung

5,0 Gt Natriumoctylsulfat
1,5 Gt Natriummetasilikat ×5 Wasser
1,0 Gt Trinatriumphosphat ×12 Wasser
92,5 Gt Wasser

mittels eines Plüschtampons entwickeln.

In der Kopie, die die Negativvorlage sehr gut differenziert wiedergibt, ist die Stufe 4 eines Halbtonstufenkeils noch voll geschwärzt.

Beispiel 10

294 Gt des in Beispiel 1 beschriebenen Polyvinylbutyrals und 10,3 Gt Maleinsäureanhydrid werden in 4170 Gt Methylethylketon gelöst und nach Zugabe von 5 Gt Triethylamin fünf Stunden zum Rückfluß erhitzt. Die erkaltete Lösung wird in 50.000 Gt Wasser eingetropft, wobei ein faseriges, weißes Polymeres ausfällt.

Analyse: C 62,0%, H 9,4%
Säurezahl: 13
Eine Beschichtungslösung aus

270 Gt des oben beschriebenen Polymeren,
165 Gt des in Beispiel 1 beschriebenen Diazoniumsalz-Kondensationsproduktes,
17 Gt Viktoriareinblau FGA,

4 Gt Phenylazodiphenylamin und
15 Gt Phosphorsäure (85%) in
10500 Gt Ethylenglykolmonomethylether,
2400 Gt Tetrahydrofuran und
800 Gt Butylacetat

wird auf den in Beispiel 2 angegebenen Schichtträger aufgebracht und getrocknet. Das Schichtgewicht beträgt 1,03 $g/m^2$.

Die Kopierschicht wird, wie in Beispiel 9 beschrieben, bildmäßig belichtet. Sie läßt sich zügig mit dem in Beispiel 10 beschriebenen Entwickler verarbeiten. Nach der Entwicklung wird sie mit einem handelsüblichen Konservierungsmittel behandelt.

Die in eine Bogenoffsetmaschine eingespannte Druckform liefert mehr als 200.000 Drucke sehr guter Qualität.

Beispiel 11

Die in Beispiel 10 beschriebene Beschichtungslösung wird auf eine in Salzsäure elektrochemisch aufgerauhte, anodisierte und wie in Beispiel 2 nachbehandelte Aluminiumfolie zu einem Trockenschichtgewicht von 0,95 $g/m^2$ aufgebracht.

Nach Belichtung und Entwicklung wird die Druckform in eine Bogenoffsetmaschine eingespannt. Der Druckversuch wird bei 170.000 Bögen abgebrochen, wobei die erhaltenen Drucke noch von ausgezeichneter Qualität sind.

Beispiel 12

Die in Beispiel 2 beschriebene Kopierschicht wird auf fünf wie in Beispiel 2 behandelte Aluminiumfolien aufgetragen.

Die fünf erhaltenen Druckplatten werden in einem auf 100°C vorgeheizten Trockenschrank eine bis fünf Stunden gelagert.

Die abgekühlten Kopierschichten werden 25 Sekunden unter einer Negativvorlage belichtet und dann mit der in Beispiel 2 beschriebenen Entwicklerlösung 45 Sekunden lang behandelt.

Während die eine bis zwei Stunden im Heizschrank gelagerten Platten gegenüber einer normal verarbeiteten Kopie keine merkliche Verlängerung des Stufenkeils und keine längere Entwicklungszeit zeigen, wird bei der drei Stunden gelagerten Platte eine etwas langsamere Entwicklung und eine Verlängerung des Keils um etwa eine Stufe beobachtet. Bei der vier Stunden gelagerten Platte zeigen sich beim Einfärben mit fetter Farbe an Nichtbildstellen erste Neigungen zum Tonen, während die fünf Stunden lang getemperte Platte auch in den Nichtbildbereichen deutlich Farbe annimmt.

Diese Ergebnisse zeigen, daß die Kopierschicht gegenüber Hitzeeinwirkung ziemlich unempfindlich ist.

Beispiele 13 bis 16

Wird das Maleinsäureanhydrid in Beispeil 1 durch gleiche Mengen der folgenden aliphatischen Dicarbonsäureanhydride ausgetauscht, so erhält man Polymere mit ähnlichen Eigenschaften, die nach Zusatz zu einer der in Beispiel 1 oder 2 beschriebenen Beschichtungslösungen und nach der dort beschriebenen Weiterverarbeitung Kopien hoher Auflösung, guter Druckwiedergabe und -auflage ergeben.

| Beispiel | Säureanhydrid | Säurezahl |
|---|---|---|
| 13 | Bersteinsäureanhydrid | 26 |
| 14 | 3,3-Tetramethylen-glutarsäureanhydrid | 14 |
| 15 | Camphersäureanhydrid | 12 |
| 16 | 3-Oxa-glutarsäureanhydrid | 27 |

Beispiel 17

Eine Beschichtungslösung aus

35,1 Gt des in Beispiel 10 beschriebenen Polymeren,
23,4 Gt des in Beispiel 4 beschriebenen Diazopolykondensats,
2,3 Gt Phosphorsäure (85%),
2,0 Gt Renolblau B2G-H (C.I. 74160) und
1,1 Gt Phenylazodiphenylamin in
1800 Gt Ethylenglykolmonomethylether und
480 Gt Butylacetat

wird auf den in Beispiel 2 angegebenen Schichtträger aufgetragen, getrocknet und wie in Beispiel 1 verarbeitet. Das Schichtgewicht beträgt 1,03 g/m$^2$.

Die kopiertechnisch sehr gut wirkende Druckform wird in eine Druckmaschine eingespannt und liefert eine hohe Anzahl sehr gut aufgelöster Drucke.

Beispiel 18

50 Gt des in Beispiel 1 beschriebenen Polyvinylbutyrals und 8 Gt 3-Oxa-glutarsäureanhydrid werden in 700 Gt Methylethylketon gelöst. Dazu wird 1 Gt Triethylamin gegeben und die Mischung fünf Stunden zum Rückfluß erhitzt. Nach Erkalten wird in 5000 Gt Wasser ausgefällt und das faserige Produkt getrocknet.

Ausbeute: 54 Gt Polymeres mit einer Säurezahl von 50.

Eine Beschichtungslösung der folgenden Zusammensetzung

15,7 Gt des oben beschriebenen Polymeren,
15,7 Gt des in Beispiel 1 beschriebenen Diazonium-Polykondensationsproduktes,
1,0 Gt Phosphorsäure (85%),
1,2 Gt Renolblau B2G-H (C.I. 74160) und
0,2 Gt Phenylazodiphenylamin in
1200 Gt Ethylenglykolmonomethylether

wird auf den in Beispiel 2 verwendeten Schichtträger aufgebracht. Das Schichtgewicht der lichtempfindlichen Schicht beträgt nach dem Trocknen 1,0 g/m$^2$.

Die Verarbeitung wird wie in Beispiel 1 angegeben durchgeführt. Mit der so erhaltenen Kopie, die sich sehr leicht verarbeiten läßt und eine steile Gradation und hohe Auflösung zeigt, wird an einer Bogenoffsetmaschine eine Druckauflage von 100.000 Bögen ohne deutliche Abnutzung der Kopie überschritten.

Beispiele 19 bis 21

In diesen Beispielen werden verschiedene hydroxylgruppenhaltige Polymere verwendet, die mit einer konstanten Menge Maleinsäureanhydrid umgesetzt werden. Die wie in Beispiel 1 hergestellten Polymeren werden in Beschichtungslösungen eingesetzt, die in ihrer Zusammensetzung der in Beispiel 17 beschriebenen entsprechen. Die Verarbeitung erfolgt wie in Beispiel 2 angegeben. In allen Fällen werden Kopien hoher Qualität erhalten, die sich in der Druckmaschine als chemisch und mechanisch außerordentlich widerstandsfähig erweisen und hohe Druckauflagen liefern.

Beispiel 19

20 Gt des in Beispiel 1 beschriebenen Polyvinylbutyrals werden mit 8 Gt Maleinsäureanhydrid in 350 Gt Methylethylketon umgesetzt und wie dort beschrieben aufgearbeitet. Die Säurezahl ist 70.

Beispiel 20

20 Gt eines Polyvinylbutyrals mit einem Molekulargewicht von etwa 70.000—80.000, das 79 Gew.-% Vinylbutyral-, 2 Gew.-% Vinylacetat- und 19 Gew.-% Vinylalkoholeinheiten enthält, werden mit 8 Gt Maleinsäureanhydrid in 350 Gt Methylethylketon umgesetzt. Die Säurezahl beträgt 73.

Beispiel 21

20 Gt eines Polyvinylbutyrals mit einem Molekulargewicht von etwa 70.000—80.000, das 86 Gew.-% Vinylbutyral-, 2 Gew.-% Vinylacetat- und 12 Gew.-% Vinylalkoholeinheiten enthält, werden mit 8 Gt Maleinsäureanhydrid in 350 Gt Methylethylketon umgesetzt. Die Säurezahl beträgt 43.

Beispiel 22

50 Gt des in Beispiel 1 beschriebenen Polyvinylbutyrals und 4 Gt Maleinsäureanhydrid werden unter Erwärmen in 725 Gt Methylethylketon gelöst und nach Zugabe von 1 Gt Triethylamin fünf Stunden zum Rückfluß erhitzt. Man erhält eine 7,42 %ige Lösung des Polymeren in Methylethylketon.

15. Gt der erhaltenen Lösung werden in Wasser eingetropft. Das erhaltene Polymere hat die in Beispiel 1 angegebene Zusammensetzung.

Eine Beschichtungslösung aus

50,5 Gt einer 7,42 %igen Lösung des oben beschriebenen Polymeren in Methylethylketon,
1,26 Gt des in Beispiel 1 beschriebenen Diazopolykondensats,
0,15 Gt Phosphorsäure (85%),
0,18 Gt Viktoriareinblau FGA und
0,04 Gt Phenylazodiphenylamin in
154 Gt Ethylenglykolmonomethylether

wird entsprechend Beispiel 1 verarbeitet.

Da die vorliegende Formulierung der in Beispiel 1 angegebenen Zusammensetzung bis auf den Ersatz von Tetrahydrofuran durch Methylethylketon entspricht, findet man erwartungsgemäß, daß die erhaltene Kopierschicht in ihren kopier- und drucktechnischen Eigenschaften mit denen der in Beispiel 1 beschriebenen Kopierschicht im wesentlichen identisch ist.

Beispiel 23

Entsprechend Beispiel 10 wird ein Polymeres mit einem Gehalt von 62,2% C, 9,4% H und mit einer Säurezahl von 12,2 als 6,8 %ige Lösung in Methylethylketon hergestellt. Das hergestellte Polymere wird dabei nicht aus dem Reaktionsmedium isoliert.

Eine Beschichtungslösung aus

258 Gt der oben beschriebenen 6,8 %igen Lösung des Polymeren in Methylethylketon,
16,7 Gt des in Beispiel 4 beschriebenen Diazoniumsalz-Polykondensats,
1,2 Gt Phosphorsäure (85%),
1,0 Gt Renolblau B2G-H und
0,55 Gt Phenylazodiphenylamin in
600 Gt Ethylenglykolmonomethylether

wird entsprechend Beispiel 17 aufgetragen und verarbeitet. Die erhaltene Kopie entspricht dabei der in Beispiel 17 beschriebenen, d.h. daß die Verwendung der Reaktionslösung einschließlich des Triethylamins keinen negativen Einfluß auf Lagerungsbeständigkeit sowie die druck- und kopiertechnischen Eigenschaften ausübt. Nach Einspannen in die Druckmaschine erhält man eine Auflage von deutlich mehr als 150.000 Bögen.

Beispiel 24

Die in Beispiel 23 beschriebene Beschichtungslösung wird derartig variiert, daß 206 Gt der dort beschriebenen 6,8-%igen Polymerlösung und 3,5 Gt des nachstehend beschriebenen Polyurethans eingesetzt werden. Das Polyurethan wurde hergestellt durch Umsetzen von 1 mol eines Präpolymeren, erhalten aus Tolylendiisocyanat und 1,1,1 - Trimethylolpropan im Molverhältnis 3:1, mit etwa 2,5 mol Hexanediol-1,6 in Tetrahydrofuran. Das Produkt wurde in Wasser ausgefällt und anschließend getrocknet.

Die Verarbeitung der Lösung erfolgt wie in Beispiel 23 angegeben, wobei man eine kaum merkliche Verlangsamung der Entwicklungsgeschwindigkeit beobachtet.

Nach dem Einspannen in eine Druckmaschine erhält man unter gleichen Bedingungen eine um etwa 20% höhere Auflage gegenüber der des vorhergehenden Beispiels. Eine Auswertung des Druckergebnisses zeigt allerdings, daß diese Platte zu einem geringfügig volleren Druckbild neigt als die Druckform des Beispiels 23.

Beispiel 25

20 Gt eines Terpolymerisats aus 91% Vinylchlorid, 3% Vinylacetat und 6% Vinylalkohol mit einem mittleren Molekulargewicht von 15.500 und einem Erweichungspunkt von 77°C wird wie in Beispiel 1 beschrieben mit 2 Gt 3 - Oxa - glutarsäureanhydrid umgesetzt. Das erhaltene Polymere hat eine Säurezahl von 24.

Eine Beschichtungslösung aus

55 Gt einer 6,4 %igen Lösung des oben beschriebenen Umsetzungsproduktes in Methylethylketon,
1,79 Gt des in Beispiel 1 beschriebenen Diazoniumsalz-Polykondensats,
0,18 Gt Phosphorsäure (85%),
0,06 Gt Phenylazodiphenylamin und
0,13 Gt Kristallviolett in
140 Gt Ethylenglykolmonomethylether

wird auf eine mechanisch aufgerauhte und mit einer 0,1 %igen wäßrigen Lösung von Polyvinylphosphonsäure nachbehandelte Aluminiumfolie aufgebracht und zu einem Schichtgewicht von 0,8 g/m$^2$ getrocknet.

Nach Belichtung und Entwicklung wie in Beispiel 1 angegeben, erhält man eine Kopie, die beim Einspannen in eine Druckmaschine einige Tausend guter Drucke ergibt.

Beispiel 26

50 Gt eines Polyvinylformals mit einem Molekulargewicht von etwa 25.000—30.000, das 68 Gew.-% Vinylformal-, 25 Gew.-% Vinylacetat- und 7 Gew.-% Vinylalkoholeinheiten enthält (OH-Zahl 85) und 4 Gt Maleinsäureanhydrid werden in 500 Gt Tetrahydrofuran klar gelöst. Zu dieser Lösung werden 10 Gt Triethylamin hinzugefügt und die sich erwärmende Lösung acht Stunden auf Rückflußtemperatur gehalten. Nach Abkühlen wird die Lösung filtriert und in 8000 Gt Wasser eingetropft, wobei man ein weißes, verhältnismäßig sprödes Produkt erhält, welches abgesaugt und getrocknet wird.

Die Ausbeute beträgt 51 Gt Polymeres, dessen Säurezahl 28 beträgt.
Eine Beschichtungslösung aus

20 Gt des oben beschriebenen Polymeren,
8 Gt des im Beispiel 1 beschriebenen Diazoniumsalz-Polykondensationsprodukts,
0,9 Gt Phosphorsäure (85%),
1,1 Gt Viktoriareinblau FGA und
0,3 Gt Phenylazodiphenylamin in
1100 Gt Ethylenglykolmonomethylether

wird auf den in Beispiel 2 beschriebenen Schichtträger aufgetragen und getrocknet. Das Schichtgewicht beträgt 0,99 $g/m^2$.

Die Kopierschicht wird unter einer Negativvorlage entsprechend Beispiel 2 belichtet und mit der dort beschriebenen Entwicklermischung behandelt.

Die so hergestellte Offset-Druckplatte besitzt eine mechanisch außerordentlich widerstandsfähige Schicht und liefert in einer Bogenoffsetmaschine einige Zehntausend Drucke von außerordentlich hoher Qualität.

Beispiel 27 (Vergleichsbeispiel)

Eine Beschichtungslösung A wurde entsprechend Beispiel 6 der DE—A—31 30 987 aus folgenden Komponenten hergestellt:

A) 15,0 Gt eines Styrol-Maleinsäureester-Copolymerisats, Erweichungspunkt 190 bis 205°C, Säurezahl ca. 200, durchschnittliches Molekulargewicht ca. 10.000,
15,0 Gt des in Beispiel 1 angegebenen Diazoniumsalz-Mischkondensats,
0,8 Gt Viktoriareinblau FGA,
0,5 Gt Phenylazodiphenylamin und
1,2 Gt Phosphorsäure (85%) in
900 Gt Ethylenglykolmonomethylether.

Eine weitere Beschichtungslösung B wurde hergestellt, indem das obige Copolymerisat durch die gleiche Menge des in Beispiel 3 beschriebenen Polymeren ersetzt wurde.

Beide Lösungen wurden auf eine wie in Beispiel 2 vorbehandelte Aluminiumfolie zu einem Schichtgewicht von 1 $g/m^2$ aufgebracht.

Beide Kopierschichten wurden unter einer Negativvorlage 22 Sekunden belichtet und mit einer Entwicklermischung folgender Zusammensetzung entwickelt:

5,0 Gt Natriumlaurylsulfat,
1,5 Gt Natriummetasilikat ×5 Wasser,
1,5 Gt Trinatriumphosphat ×12 Wasser,
92 Gt Wasser.

Folgende Ergebnisse werden dabei erzielt:

Die Lichtempfindlichkeiten beider zu vergleichender Kopierschichten A und B sind fast identisch. Der Kontrast der belichteten, noch nicht entwickelten Platte B ist deutlich besser und für das Auge freundlicher als der der Platte A.

Nach der Entwicklung, die in beiden Fällen zügig verläuft, erhält man insgesamt vergleichbare Kopien, allerdings ist die Gradation der Kopie B etwas steiler als die der Kopie A. Beide Platten werden zu Vergleichszwecken in eine Druckmaschine gespannt.

Man findet folgende Ergebnisse:

Beim Andruck nimmt die Platte B deutlich rascher Farbe an (Faktor 2—3) als die Platte A. Bei Verwendung eines alkalischen Wischwassers wird dieser Effekt noch deutlicher.

Im Fortdruck zeigt sich, daß die Platte B deutlich offener druckt als die Platte A.

Weiterhin zeigt die Platte A bereits nach 80.000 Drucken Unruhen im Raster, der Halbtonstufenkeil ist um zwei Stufen verkürzt wiedergegeben. Die Platte B zeigt bei dieser Druckauflage keinerlei Unruhe im Raster, der Halbtonstufenkeil ist um etwa eine Stufe verkürzt wiedergegeben.

Nach 100.000 Drucken zeigt die Platte A erste Schichtausbrüche, während Raster und Volltöne der Platte B auch nach 150.000 Drucken noch keinerlei Beschädigungen aufweisen.

Insgesamt läßt sich also feststellen, daß die erfindungsgemäße Druckplatte B der bekannten Druckplatte A in wesentlichen Kriterien überlegen ist.

Beispiel 28 (Vergleichsbeispiel)

Entsprechend dem Beispiel 27 werden zwei Beschichtungslösungen A 1 (DE—A—31 30 987) und B 1 (erfindungsgemäß) hergestellt, in denen der Farbstoff Viktoriareinblau FGA durch Renolblau B2G-H ersetzt wird.

Die Beschichtung, Belichtung und Entwicklung erfolgt wie im Beispiel 27 angegeben.

Es zeigt sich, daß der eingesetzte Farbstoff mit dem Bindemittel der Platte A 1 nicht verträglich ist und agglomeriert. Die Kopie erscheint bläßlich grau, auch nach der Entwicklung ist der Kontrast unzureichend. Die Gradation der Kopie B 1 ist viel steiler als die der Kopie A 1. Beim Auflagendruck mit den Platten A 1 und B 1 werden die oben beschriebenen Ergebnisse im wesentlichen reproduziert.

**Patentansprüche**

1. Lichtempfindliches Gemisch, das ein Diazoniumsalz-Polykondensationsprodukt und ein nicht lichtempfindliches polymeres Bindemittel mit seitenständigen Carboxylgruppen enthält, das in wäßrig-alkalischen Lösungen löslich oder mindestens quellbar ist, dadurch gekennzeichnet, daß das Bindemittel ein Umsetzungsprodukt eines intramolekularen Anhydrids einer organischen Di- oder Tricarbonsäure mit einem Vinylalkoholeinheiten enthaltenden synthetischen Polymeren ist, das keine weiteren zur Umsetzung mit Säureanhydriden befähigten funktionellen Gruppen enthält.

2. Lichtempfindliches Gemisch nach Anspruch 1, dadurch gekennzeichnet, daß das Säureanhydrid eine Verbindung einer der Formeln (I), (II) und (III)

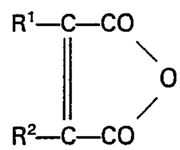

(I)

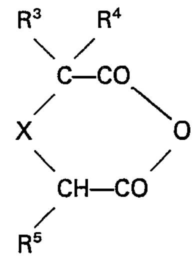

(II)

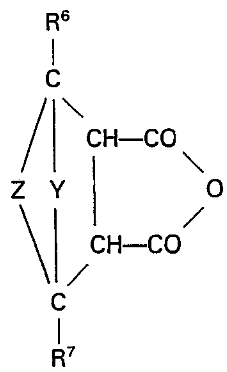

(III)

ist, worin

$R^1$ und $R^2$ einzeln Wasserstoffatome oder Alkylgruppen bedeuten oder miteinander zu einem aromatischen oder heteroaromatischen, gegebenenfalls substituierten und ggf. teilweise hydrierten 5- oder 6-gliedrigen Ring verbunden sind, an den bis zu zwei aromatische oder cycloaliphatische Ringe ankondensiert sein können,

$R^3$, $R^4$ und $R^5$ einzeln Wasserstoffatome oder Alkylgruppen bedeuten oder

$R^3$ und $R^5$ miteinander zu einem ggf. substituierten gesättigten oder ungesättigten aliphatischen Ring verbunden sind, der einschließlich X fünf oder sechs Ringglieder haben kann,

$R^6$ und $R^7$ Wasserstoffatome oder Alkylgruppen,

X eine Einfachbindung, eine 1,1 - Alkylengruppe, eine 1,1 - Cycloalkylengruppe, die ggf. substituiert sind, ein Sauerstoff- oder Schwefelatom,

Y ein Sauerstoff- oder Schwefelatom, eine 1,1- oder 1,2-Alkylengruppe oder eine 1,2-Alkenylengruppe, an die ggf. ein aromatischer oder cycloaliphatischer Ring ankondensiert ist, und

Z die zur Vervollständigung eines gesättigten oder ungesättigten ggf. substituierten Rings erforderlichen Ringglieder bedeuten, wobei an diesen Ring bis zu zwei aromatische oder cycloaliphatische Ringe ankondensiert sein können.

3. Lichtempfindliches Gemisch nach Anspruch 2, dadurch gekennzeichnet, daß das Säureanhydrid Maleinsäureanhydrid, Phthalsäureanhydrid, Bernsteinsäureanhydrid oder 3-Oxaglutarsäureanhydrid ist.

4. Lichtempfindliches Gemisch nach Anspruch 2, dadurch gekennzeichnet, daß das Säureanhydrid das Produkt einer Diels-Alder-Reaktion eines Diens mit Maleinsäureanhydrid ist.

5. Lichtempfindliches Gemisch nach Anspruch 1, dadurch gekennzeichnet, daß das Vinylalkoholeinheiten enthaltende synthetische Polymere ein Polyvinylacetal oder ein Polyvinylacetat mit freien Hydroxylgruppen ist.

6. Lichtempfindliches Gemisch nach Anspruch 1, dadurch gekennzeichnet, daß das negativ arbeitende Diazoniumsalz-Polykondensationsprodukt aus wiederkehrenden Einheiten $A—N_2X$ und B besteht, die

durch Zwischenglieder, vorzugsweise Methylengruppen, miteinander verbunden sind, die von kondensationsfähigen Carbonylverbindungen abgeleitet sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines Phenols, Phenolethers, aromatischen Thioethers, eines aromatischen Kohlenwasserstoffs, einer aromatischen heterocyclischen Verbindung oder eines organischen Säureamids ist.

7. Lichtempfindliches Gemisch nach Anspruch 6, dadurch gekennzeichnet, daß das Diazoniumsalz-Polykondensationsprodukt ein Produkt mit wiederkehrenden Einheiten $A—N_2X$ und B ist, die durch zweibindige, von einer kondensationsfähigen Carbonylverbindung abgeleitete Zwischenglieder verbunden sind, wobei die Einheiten $A—N_2X$ sich aus Verbindungen der allgemeinen Formel

$$(R^8—R^9—)_pR^{10}—N_2X$$

ableiten und wobei

X das Anion der Diazoniumverbindung,

p eine ganze Zahl von 1 bis 3,

$R^8$ einen aromatischen Rest mit mindestens einer zur Kondensation mit aktiver Carbonylverbindung befähigten Position,

$R^{10}$ eine Phenylengruppe,

$R^9$ eine Einfachbindung oder eine der Gruppen:

$—(CH_2)_q—NR^{11}—$,
$—O—(CH_2)_r—NR^{11}—$,
$—S—(CH_2)_r—NR^{11}—$,
$—S—CH_2CO—NR^{11}—$,
$—O—R^{12}—O—$,
$—O—$
$—S—$ oder
$—CO—NR^{11}—$

bedeuten, worin

q eine Zahl von 0 bis 5,

r eine Zahl von 2 bis 5,

$R^{11}$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und

$R^{12}$ eine Arylengruppe mit 6 bis 12 C-Atomen ist, und

B den von Diazoniumgruppen freien Rest eines aromatischen Amins, Phenols, Thiophenols, Phenolethers, aromatischen Thioethers, aromatischen Kohlenwasserstoffs, einer aromatischen heterocyclischen Verbindung oder eines organischen Säureamids bedeuten.

8. Lichtempfindliches Gemisch nach Anspruch 1, dadurch gekennzeichnet, daß es zusätzlich ein Polyamid oder ein Polyurethan in einer Menge bis zu 40 Gew.-% des Bindemittels mit seitenständigen Carboxylgruppen enthält.

9. Lichtempfindliches Aufzeichnungsmaterial aus einem Schichtträger und einer lichtempfindlichen Schicht, dadurch gekennzeichnet, daß die lichtempfindliche Schicht aus einem Gemisch gemäß Anspruch 1 besteht.

**Revendications**

1. Composition photosensible contenant un produit de polycondensation d'un sel de diazonium et un liant polymère non photosensible à groupes carboxy latéraux qui est soluble ou au moins susceptible de gonfler dans des solutions aqueuses alcalines, caractérisée en ce que le liant est un produit de réaction d'un anhydride intramoléculaire d'un acide organique di- ou tricarboxylique avec un polymère synthétique contenant des motifs alcool vinylique, qui ne contient pas d'autres groupes fonctionnels susceptibles de réagir avec des anhydrides d'acide.

2. Composition photosensible selon la revendication 1, caractérisée en ce que l'anhydride d'acide est un composé de formule (I), (II) ou (III)

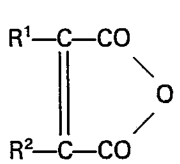
(I)

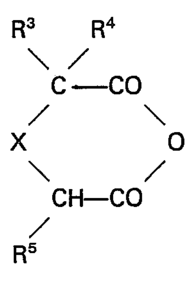
(II)

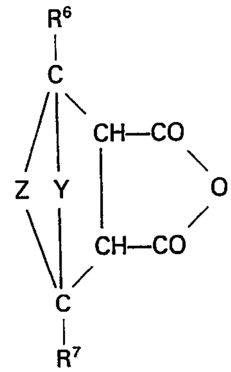

(III)

dans lesquelles

$R^1$ et $R^2$ représentent individuellement des atomes d'hydrogène ou des groupes alkyle, ou sont liés l'un à l'autre en un cycle aromatique ou hétéroaromatique à 5 ou 6 chaînons, éventuellement substitué et éventuellement partiellement hydrogéné, auquel peuvent être soudés jusqu'à deux cycles aromatiques ou cycloaliphatiques,

$R^3$, $R^4$ et $R^5$ représentent individuellement des atomes d'hydrogène ou des groupes alkyle, ou $R^3$ et $R^5$ sont liés l'un à l'autre en un cycle aliphatique saturé ou non saturé éventuellement substitué, qui peut comporter, y compris X, 5 ou 6 chaînons de cycle,

$R^6$ et $R^7$ représentent des atomes d'hydrogène ou des groupes alkyle,

X représente une simple liaison, un groupe 1,1-alkylène ou un groupe 1,1-cycloalkylène qui sont éventuellement substitués, un atome d'oxygène ou de soufre,

Y représente un atome d'oxygène ou de soufre, un groupe 1,1- ou 1,2-alkylène ou un groupe 1,2-alcénylène auxquels est éventuellement soudé un cycle aromatique ou cycloaliphatique, et

Z représente les chaînons de cycle requis pour l'achèvement d'un cycle saturé ou insaturé éventuellement substitué, jusqu'à deux cycles aromatiques ou cycloaliphatiques pouvant être soudés à ce cycle.

3. Composition photosensible selon la revendication 2, caractérisée en ce que l'anhydride d'acide est l'anhydride maléique, l'anhydride phtalique, l'anhydride succinique ou l'anhydride 3-oxaglutarique.

4. Composition photosensible selon la revendication 2, caractérisée en ce que l'anhydride d'acide est le produit d'une réaction de Diels-Alder d'un diène avec l'anhydride maléique.

5. Composition photosensible selon la revendication 1, caractérisée en ce que le polymère synthétique contenant des motifs alcool vinylique est un poly(acétal de vinyle) ou un poly(acétate de vinyle) à groupes hydroxy libres.

6. Composition photosensible selon la revendication 1, caractérisée en ce que le produit de polycondensation de sel de diazonium travaillant en négatif est constitué de motifs répétitifs $A—N_2X$ et B qui sont liés les uns aux autres par des chaînons intermédiaires, de préférence des groupes méthylène, qui sont dérivés de composés carbonyle condensables, A étant le reste d'un composé diazonium aromatique condensable avec le formaldéhyde et B étant le reste d'un composé exempt de groupes diazonium, condensable avec le formaldéhyde, en particulier d'une amine aromatique, d'un phénol, phénoléther, thioéther aromatique, d'un hydrocarbure aromatique, d'un composé hétérocyclique aromatique ou d'un amide organique.

7. Composition photosensible selon la revendication 6, caractérisée en ce que le produit de polycondensation de sel de diazonium est un produit comportant des motifs répétitifs $A—N_2X$ et B qui sont liés par des chaînons intermédiaires bivalents dérivés d'un composé carbonyle condensable, les motifs $A—N_2X$ dérivant de composés de formule générale

$$(R^8—R^9—)_pR^{10}—N_2X$$

et

X représentant l'anion du composé diazonium.

p étant un nombre entier allant de 1 à 3,

$R^8$ représentant un radical aromatique comportant au moins une position apte à la condensation avec un composé carbonyle actif,

$R^{10}$ représentant le groupe phénylène,

$R^9$ représentant une simple liaison ou l'un des groupes:

$—(CH_2)_q—NR^{11}—$,

$—O—(CH_2)_r—NR^{11}—$,

$—S—(CH_2)_r—NR^{11}—$,

$—S—CH_2CO—NR^{11}—$,

$—O—R^{12}—O—$,

$—O—$,

$—S—$ ou

$—CO—NR^{11}—$,

dans lesquels

q est un nombre allant de 0 à 5,

r est un nombre allant de 2 à 5,

$R^{11}$ représente un atome d'hydrogène, un groupe alkyle ayant de 1 à 5 atomes de carbone, un groupe aralkyle ayant de 7 à 12 atomes de carbone, ou un groupe aryle ayant de 6 à 12 atomes de carbone, et

$R^{12}$ représente un groupe arylène ayant de 6 à 12 atomes de carbone, et

B représentant le reste exempt de groupes diazonium d'une amine aromatique, d'un phénol, thiophénol, phénol-éther, thioéther aromatique, hydrocarbure aromatique, d'un composé hétérocyclique aromatique ou d'un amide organique.

8. Composition photosensible selon la revendication 1, caractérisée en ce qu'elle contient en outre un polyamide ou un polyuréthanne en une quantité représentant jusqu'à 40% en poids du liant à groupes carboxy latéraux.

9. Matériau reprographique photosensible constitué d'un support de couche et d'une couche photosensible, caractérisé en ce que la couche photosensible est constituée d'une composition selon la revendication 1.

**Claims**

1. Photosensitive composition which comprises a diazonium salt polycondensation product and a non-photosensitive polymeric binder with carboxyl side groups, which is soluble or at least swellable in aqueous-alkaline solutions, characterized in that the binder comprises a reaction product of an intramolecular anhydride of an organic di- or tricarboxylic acid with a synthetic polymer containing vinyl alcohol units and having no further functional groups which are capable of reaction with acid anhydrides.

2. A photosensitive composition as claimed in claim 1, characterized in that the acid anhydride comprises a compound corresponding to one of the formulae (I), (II) or (III)

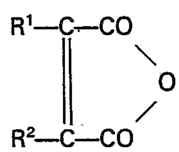

(I)

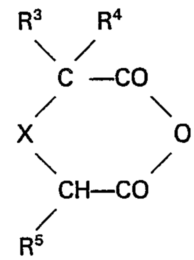

(II)

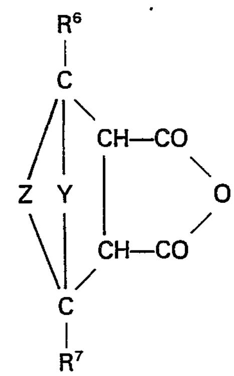

(III)

wherein

$R^1$ and $R^2$ individually denote hydrogen atoms or alkyl groups or are interconnected to form an aromatic or heteroaromatic, unsubstituted or substituted and optionally partially hydrogenated five-membered or six-membered ring which may be fused with up two aromatic or cycloaliphatic rings,

$R^3$, $R^4$ and $R^5$ individually denote hydrogen atoms or alkyl groups or

$R^3$ and $R^5$ are interconnected to form an unsubstituted or substituted saturated or unsaturated aliphatic ring which, inclusive of X, may have five or six ring members,

$R^6$ and $R^7$ are hydrogen atoms or alkyl groups,

X is a single bond, an unsubstituted or substituted 1,1-alkylene group or 1,1-cycloalkylene group, an oxygen atom or a sulfur atom,

Y is an oxygen atom or a sulfur atom, a 1,1- or 1,2-alkylene group or a 1,2-alkenylene group, which may optionally be fused with an aromatic or cycloaliphatic ring, and

Z stands for the ring members required for the completion of a saturated or unsaturated, unsubstituted or substituted ring, this ring optionally being fused with up to two aromatic or cycloaliphatic rings.

3. A photosensitive composition as claimed in claim 2, characterized in that the acid anhydride comprises maleic anhydride, phthalic anhydride, succinic anhydride or 3-oxa-glutaric anhydride.

4. A photosensitive composition as claimed in claim 2, characterized in that the acid anhydride comprises the product formed in the Diels-Alder reaction of a diene with maleic anhydride.

5. A photosensitive composition as claimed in claim 12, characterized in that the synthetic polymer containing vinyl alcohol units comprises a polyvinyl acetal or a polyvinyl acetate, having free hydroxyl groups.

6. A photosensitive composition as claimed in claim 12, characterized in that the negative-working diazonium salt polycondensation product comprises recurrent units $A—N_2X$ and B, which are linked by intermediate members, preferably methylene groups, which are derived from condensible carbonyl compounds, with A being the radical of an aromatic diazonium compound which is capable of condensation with formaldehyde and B being the radical of a compound which is free of diazonium groups and is capable of condensation with formaldehyde, particularly of an aromatic amine, a phenol, phenol ether, aromatic thioether, an aromatic hydrocarbon, an aromatic heterocyclic compound or an organic acid amide.

7. A photosensitive composition as claimed in claim 6, characterized in that the diazonium salt polycondensation product comprises a product having recurrent units $A—N_2X$ and B, which are linked by bivalent intermediate members derived from a carbonyl compound which is capable of condensation, the units $A—N_2X$ being derived from compounds corresponding to the general formula

$$(R^8—R^9—)_pR^{10}—N_2X$$

wherein

X is the anion of the diazonium compound,

p is an integer from 1 to 3,

$R^8$ is an aromatic radical which is capable of condensation with an active carbonyl compound, in at least one position,

$R^{10}$ is a phenylene group, and

$R^9$ is a single bond or one of the groups:

$—(CH_2)_q—NR^{11}—$,
$—O—(CH_2)_r—NR^{11}—$,
$—S—(CH_2)_r—NR^{11}—$,
$—S—CH_2CO—NR^{11}—$,
$—O—R^{12}—O—$,
$—O—$,
$—S—$, or
$—CO—NR^{11}—$,

wherein

q is a number from 0 to 5,

r is a number from 2 to 5,

$R^{11}$ is a hydrogen atom, an alkyl group having from 1 to 5 carbon atoms, an aralkyl group having from 7 to 12 carbon atoms or an aryl group having from 6 to 12 carbon atoms, and

$R^{12}$ is an arylene group having from 6 to 12 carbon atoms, and

B being the radical of an aromatic amine, phenol, thiophenol, phenolether, aromatic thioether, aromatic hydrocarbon, an aromatic heterocyclic compound, or an organic acid amide, which radical is free of diazonium groups.

8. A photosensitive composition as claimed in claim 2, characterized in that it additionally contains a polyamide or a polyurethane in an amount of up to 40 percent by weight, based on the weight of the binder having carboxyl side groups.

9. Photosensitive recording material comprising a support and a photosensitive coating, wherein the photosensitive coating comprises a composition as claimed in claim 1.